## Europäisches Patentamt
## European Patent Office
## Office européen des brevets

(19)

(11) Veröffentlichungsnummer: **0 117 921**
**B1**

(12) ## EUROPÄISCHE PATENTSCHRIFT

(45) Veröffentlichungstag der Patentschrift:
**11.03.87**

(51) Int. Cl.⁴: **G 01 H 3/12**

(21) Anmeldenummer: **83113079.4**

(22) Anmeldetag: **23.12.83**

(54) **Verfahren zum Herstellen einer Vorrichtung zur Auslese eines zweidimensionalen Ladungsbildes mit einem Array.**

(30) Priorität: **12.01.83 DE 3300831**

(43) Veröffentlichungstag der Anmeldung:
**12.09.84 Patentblatt 84/37**

(45) Bekanntmachung des Hinweises auf die Patenterteilung:
**11.03.87 Patentblatt 87/11**

(84) Benannte Vertragsstaaten:
**DE FR GB NL**

(56) Entgegenhaltungen:
**GB - A - 1 530 783**
**US - A - 3 952 387**

**IEEE TRANSACTIONS ON COMPONENTS, HYBRIDS
AND MANUFACTURING TECHNOLOGY, Band CHMT-4,
Nr. 4, Dezember 1981, Seiten 361-366, New York, USA;
P.L. SCARFF et al.: "Laser-patterned Ta2N resistors for
thin film circuits"**

(73) Patentinhaber: **Siemens Aktiengesellschaft Berlin und
München, Wittelsbacherplatz 2, D-8000 München 2 (DE)**

(72) Erfinder: **Sachs, Bertram, Dorfstrasse 30,
D-8520 Erlangen (DE)**

## Beschreibung

In der DE-AI-3 224 026, Prioritätstag 28.6.82, Veröffentlichungstag 29.12.83, ist eine Auslesevorrichtung aus gestapelten Leiterplatten beschrieben, bei denen jeweils eine ihrer Flachseiten mit schaltbaren Verstärkern versehen ist, denen jeweils ein Ableitwiderstand zugeordnet ist, und bei denen jeweils eine Schmalseite und ein Teil dieser mit Ableitwiderständen versehenen angrenzenden Flachseite mit einem dünnen Film aus elektrisch leitendem Material versehen ist. Bei dieser Vorrichtung ist jeweils eine Flachseite der Leiterplatten mit einer parallel zu den Schmalseiten verlaufenden Aussparung versehen. Den Elektroden der Leiterplatten sind jeweils ein schaltbarer Verstärker, beispielsweise ein Dual-Gate-MOS-FET, zugeordnet, die in der Längsrichtung der Aussparung hintereinander angeordnet sind. Die Verbindungsleiter sind wenigstens annähernd gleich lang zwischen den Elektroden und jeweils den entsprechenden schaltbaren Verstärkern. Die Hauptsteuerleitungen sind auf den den Elektroden gegenüberliegenden Schmalseiten der Leiterplatten in Richtung der Spalten angeordnet, welche jeweils die zur gleichen Spalte gehörenden Steuerleitungen der schaltbaren Verstärker der Leiterplatten elektrisch leitend miteinander verbinden. Die Masseleitungen der Leiterplatten sind ausserhalb der Leiterplatten mit einer Masseschiene verbunden.

Zum Herstellen dieser Vorrichtung werden im allgemeinen die auf einer gemeinsamen Flachseite der Leiterplatten angeordneten Verbindungsleiter und die Steuerleitungen sowie die Signalleitung, die Masseleitung und die Ableitwiderstände in Dünnfilmtechnik hergestellt. Dazu werden die Schmalseite und die angrenzende Flachseite vollflächig mit einem dünnen Film aus elektrisch leitendem Material versehen. Dieser dünne Film wird vorzugsweise aufgedampft, insbesondere aufgesputtert. Anschliessend werden die Verbindungsleiter, die Steuerleitungen, die Signalleitung, die Masseleitung und die Ableitwiderstände in bekannter Lithographietechnik durch Entfernen der überflüssigen Teile des aufgebrachten Films ausgebildet. Die Aufteilung des dünnen Films der Schmalseite in einzelne Elektroden kann beispielsweise mittels einer Säge durchgeführt werden. Man kann auch auf fototechnischem Wege die einzelnen Elektroden aus dem dünnen Film herausarbeiten.

Der Erfindung liegt nun die Aufgabe zugrunde, diese Art der Herstellung der Vorrichtung zu verbessern, insbesondere soll die Herstellung der Elektroden auf den Schmalseiten der Leiterplatten vereinfacht werden.

Diese Aufgabe wird erfindungsgemäss durch ein Verfahren nach dem Anspruch 1 gelöst. Durch dieses Verfahren erreicht man, dass jeweils der dünne Film der Schmalseite und der Flachseite einer grösseren Anzahl, vorzugsweise mehrere 100, Leiterplatten, in einzelne Elektroden getrennt wird. Durch dieses Verfahren erhält man jeweils eine grössere Anzahl von Elektroden auf den Schmalseiten der Leiterplatten und demzufolge eine grössere Auflösung des Ladungsbildes und man kann Schnitte im μm-Bereich herstellen. Ausserdem entstehen bei diesem Auftrennen des dünnen Films in einzelne Elektroden keine Späne, die unter Umständen eine saubere Aufteilung der Leiterplatten in einzelne Elemente verhindern könnte.

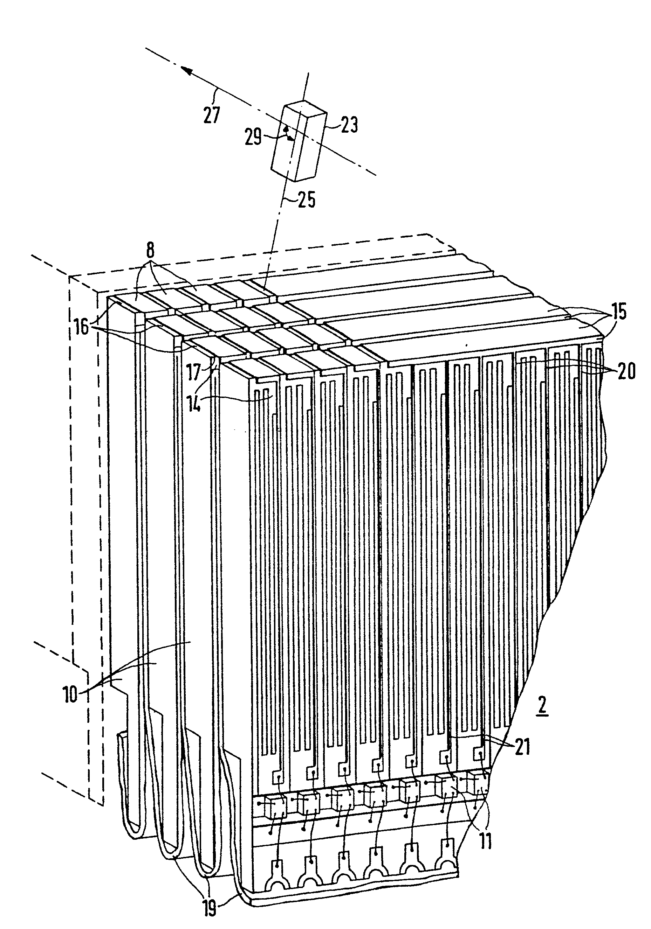

Zur weiteren Erläuterung wird auf die Zeichnung Bezug genommen, die zur Erläuterung der Verfahrensschritte nach der Erfindung dient.

In der Figur ist ein Stapel 2 von Leiterplatten 10 vorgesehen, die auf einer ihrer Flachseiten 14 bereits mit Bauelementen versehen sind und aus denen jeweils ein Modul für eine Vorrichtung zur Auslese eines zweidimensionalen Ladungsbildes mit einem Array hergestellt werden soll. Der Stapel 2 enthält mehrere, vorzugsweise mehrere 100, gestapelte Leiterpaltten 10, bei denen jeweils eine ihrer Flachseiten 14 mit schaltbaren Verstärkern 11 versehen ist, denen jeweils ein Ableitwiderstand 21 zugeordnet ist. Jeweils eine Schmalseite 16 der Leiterplatten 10 und ein Teil dieser mit Ableitwiderständen 21 versehenen angrenzenden Flachseiten 14 sind mit einem dünnen Film 15 aus elektrisch leitendem Material versehen. Die Schnittgerade der Schmalseite 16 mit der angrenzenden Flachseite 14 ist eine Aussenkante 17 der Leiterplatte 10. Dieser dünne Film 15 der Flachseite 14 ist beispielsweise nur einige mm breit und schaltet somit alle Verbindungsleitungen 20 und damit alle Ableitwiderstände 21 der Leiterplatte 10 parallel. Beim Stapeln der einzelnen Leiterplatten 10 wird jeweils zwischen zwei Leiterplatten 10 beispielsweise eine Abstandsfolie 19 eingelegt, die vom laufenden Meter als Falte zwischen zwei Leiterplatten 10 angeordnet wird. Danach wird ein Laser 23 über die Schmalseiten 16 der gestapelten Leiterplatten 10 so geführt, dass zwischen dem Laserstrahl 25 und der Bewegungsrichtung des Lasers 23, die in der Figur durch einen Pfeil 27 angedeutet ist, ein spitzer Winkel 29 eingehalten wird. Mit diesem über die Schmalseite 16 der gestapelten Leiterplatten 10 geführten Laser 23, wird jeweils der dünne Film 15 der Schmalseiten 16 und der Flachseiten 14 in einzelne Elektroden 8 getrennt, die somit jeweils eine Verbindung um eine Aussenkante herstellen.

Mit diesem Verfahren kann man um Aussenkanten führende elektrische Anschlüsse herstellen. Damit erhält man Verbindungsstellen ohne Erhöhungen; denn diese Erhöhungen würden beispielsweise die Empfindlichkeit einer Folie aus Polyvinylidenfluorid PVDF, die gegebenenfalls nachträglich auf die Elektroden 8 aufgeklebt wird, wesentlich vermindern. Ausserdem kann man mit diesem Verfahren eine entsprechend grössere Anzahl von Elektroden 8 auf den Schmalseiten 16 der Leiterplatten 10 herstellen und erhält demzufolge eine grössere Auflösung des Ladungsbildes.

## Patentansprüche

1. Verfahren zum Herstellen einer Vorrichtung zur Auslese eines zweidimensionalen Ladungsbildes, ausgehend von einem Array (2) aus gestapelten Leiterplatten (10), bei denen jeweils eine ihrer Flachseiten (14) mit schaltbaren Verstärkern (11) versehen ist, denen jeweils ein Ableitwiderstand (21) zugeordnet ist, und bei denen jeweils eine Schmalseite (16) und ein Teil dieser mit Ableitwiderständen (21) versehenen angrenzenden Flachseite (14) mit einem dünnen Film (15) aus elektrisch leitendem Material versehen ist, wobei nun mit einem Laserstrahl (25), der über die Schmalseiten (16) der gestapelten Leiterplatten (10) geführt wird, jeweils dieser dünne Film (15) der Schmalseiten (16) und der Flachseiten (14) in einzelne Elektroden (8) getrennt wird.

2. Verfahren nach Anspruch 1, wobei zwischen dem Laserstrahl (25) und der Bewegungsrichtung des Lasers (23) ein spitzer Winkel (29) eingehalten wird.

3. Verfahren nach Anspruch 1 oder 2, wobei beim Stapeln der einzelnen Leiterplatten (10) jeweils zwischen zwei Leiterplatten (10) eine Abstandsfolie (19) eingelegt wird.

## Revendications

1. Procédé pour fabriquer un dispositif de lecture d'une image de charges bidimensionnelle, à partir d'un réseau (2) de plaquettes empilées de circuits imprimés (10), dont un côté plat respectif (14) est équipé d'amplificateurs commutables (11), à chacun desquels est associée une résistance respective de dérivation (21), et dont un petit côté respectif (16) et une partie de ce côté plat contigu, muni de résistances de dérivation (21), sont munis d'une couche mince (15) constituée en un matériau électriquement conducteur, et selon lequel on subdivise respectivement cette couche mince (15) du petit côté (16) et du côté plat (14) en électrodes individuelles (8) par l'intermédiaire d'un faisceau laser (25), que l'on déplace sur les petits côtés (16) des plaquettes empilées de circuits imprimés (10).

2. Procédé suivant la revendication 1, selon lequel on maintient un angle aigu (29) entre le faisceau laser (25) et la direction de déplacement du laser (23).

3. Procédé suivant la revendication 1 ou 2, selon lequel on insère une feuille entretoise (19) respectivement entre deux plaquettes de circuits imprimés (10) lors de l'empilage des différentes plaquettes de circuits imprimés (10).

## Claims

1. A method of producing a device for reading a two-dimensional charge image emitted by an array (2) comprising stacked circuit boards (10), where one of the flat sides (14) of each of the circuit boards (10) is provided with switchable amplifiers (11), each of which is assigned a shunt resistor (21) and where one narrow side (16) and a part of whose adjacent flat side (14), which is provided with shunt resistors (21), of the circuit boards (10) is provided with a thin film (15) of electrically conductive material, where, using a laser beam (25) which is moved over the narrow sides (16) of the stacked circuit boards (10), the thin film (15) applied to the narrow sides (16) and the flat sides (14) is split into individual electrodes (8).

2. A method as claimed in claim 1, wherein an acute angle (29) is maintained between the laser beam (25) and the direction of movement of the laser (23).

3. A method as claimed in claim 1 or 2, wherein a spacer foil (19) is interposed between every two circuit boards (10) during the stacking of the individual circuit boards (10).